(19) Europäisches Patentamt
European Patent Office
Office européen des brevets

(11) **EP 0 701 917 A1**

(12) **EUROPÄISCHE PATENTANMELDUNG**

(43) Veröffentlichungstag:
20.03.1996 Patentblatt 1996/12

(51) Int. Cl.⁶: **B60K 28/04**, H03K 17/96

(21) Anmeldenummer: 95114476.5

(22) Anmeldetag: 14.09.1995

(84) Benannte Vertragsstaaten:
**AT CH DE FR GB IT LI NL**

(30) Priorität: **15.09.1994 DE 4432936**

(71) Anmelder: **Agria-Werke GmbH**
**D-74219 Möckmühl (DE)**

(72) Erfinder:
• **Martin, Felix**
**D-74629 Pfedelbach (DE)**

• **Hemmerich, Frank**
**D-74219 Möckmühl (DE)**

(74) Vertreter: **Haug, Dietmar, Dipl.-Ing. et al**
**Patentanwälte**
**Andrae, Flach, Haug, Kneissl**
**Balanstrasse 55**
**D-81541 München (DE)**

(54) **Totmanneinrichtung, insbesondere für mitgängergeführte und/oder handgehaltene motorbetriebene Bearbeitungsmaschinen**

(57)    Die vorliegende Erfindung betrifft eine Totmanneinrichtung, insbesondere für mitgängergeführte und/oder handgehaltene motorbetriebene Bearbeitungsmaschinen, mit mindestens einem Handgriff zum Führen und/oder Halten der Maschine, einem Sicherheitskreis und einer Auswertelektronik mit zugehöriger Schaltung.

Zur Erfassung der Hand des Benutzers an einem Handgriff (1) wird ein kapazitiver Sensor (2) verwendet. Der kapazitive Sensor (2) umfaßt innen eine Kupferfolie (3), die zwischen zwei Kunststoffschichten oder -folien (4) und (5) eingebettet ist. Die Kupferfolie (3) ist über ein kapazitätsarmes Koaxialkabel (6) mit einer Aus-wert-elektronik verbunden.

FIG. 1b

**Beschreibung**

Die vorliegende Erfindung betrifft eine Totmanneinrichtung, insbesondere für mitgängergeführte und/oder handgehaltene motorbetriebene Bearbeitungsmaschinen, mit mindestens einem Handgriff zum Führen und/oder Halten der Maschine, einem Sicherheitskreis und einer Auswertelektronik mit zugehöriger Schaltung.

Aus dem Stand der Technik sind verschiedene Totmanneinrichtungen für Maschinen bekannt, die meist mechanisch ausgelöst werden. Derartige Totmanneinrichtungen werden z.B. durch am Griff angebrachte Hebel oder Drücker ausgelöst, die beim Betrieb der Maschine in einer Betriebsposition gehalten werden müssen. Dazu müssen die Hebel oder Drücker durch eine Hand oder beide Hände des Benutzers mit einer Kraft beaufschlagt werden, die zusätzlich zu der zum Führen oder Halten der Maschinen benötigten Kraft aufzubringen ist. Das Aufbringen dieser zusätzlichen Kraft ist lästig und kann zu Krämpfen führen.

Ein weiteres Problem ergibt sich bei mitgängergeführten Bearbeitungsmaschinen mit zwei Handgriffen. Beim Betreiben solcher Maschinen kommt es in der Praxis häufig vor, daß die Maschine kurzfristig mit nur einer Hand geführt werden muß, um z.B. einem Hindernis auszuweichen.

Aufgabe der vorliegenden Erfindung ist es, eine Totmanneinrichtung der eingangs genannten Art zu schaffen, mit der die Maschine betrieben werden kann, ohne daß durch den Benutzer eine zusätzliche, nicht zur Bedienung der Maschine erforderliche Kraft aufgebracht werden muß und mit der es gegebenenfalls möglich ist, Maschinen mit zwei Handgriffen kurzfristig auch mit einer Hand zu bedienen, ohne daß die Maschine abgeschaltet wird.

Diese Aufgabe wird durch die im Kennzeichen des Patentanspruchs 1 gegebene Lehre gelöst.

Zur Erfassung der Hand des Benutzers am Griff wird eine kapazitive Abtastmethode benutzt. Dafür wird ein Handgriff verwendet, der innen eine Kupferfolie umfaßt, die zwischen zwei Kunststoffschichten oder -folien eingebettet ist. Die Kupferfolie ist über ein kapazitätsarmes Koaxialkabel mit einer Auswertelektronik verbunden.

Bei einem idealen Plattenkondensator gilt für die Kapazität $C = \varepsilon_0 \times \varepsilon_r \times A/d$. $\varepsilon_0$ ist eine Naturkonstante (absolute Dielektrizitätskonstante). $\varepsilon_r$ ist die relative Dielektrizitätskonstante (abhängig vom verwendeten Werkstoff). A ist die Kondensatorfläche und d ist die Dicke des Dielektrikums.

Der Handgriff wird z.B. über einen Stahlholm einer Maschinenlenkstange gestülpt. Dadurch ergibt sich zwischen Kupferfolie und dem inneren Dielektrikum eine bestimmte Grundkapazität $C_0$, die einem ersten Kondensator entspricht und konstant ist. Die Kupferfolie bildet in Verbindung mit der äußeren Kunststoffschicht einen zweiten Kondensator zur Hand des Bedienpersonals bzw. zur Erde mit einer Kapazität $C_{var}$. Die Kapazität $C_{var}$ ist normalerweise vernachlässigbar klein. Bei Berührung des Handgriffs durch eine Person gibt es einen Schluß und es treten Kapazitätsänderungen von 10-20 pF auf. Diese Kapazitätsänderungen werden durch einen Oszillator als Frequenzänderung erfaßt und mit einer geeigneten Auswertelogik in eine digitale Information umgesetzt.

Im kapazitiven Handgriff liegt aufgrund der mechanischen Ausführung zur Maschine eine feste Grundkapazität $C_0$ vor. Der zweite Kondensator $C_{var}$ gibt, bedingt durch die Hand des Maschinenführers, eine neue Kapazität. Es gilt nun, diese Kapazität $C_{var}$ im Verhältnis zu $C_0$ möglichst groß auszuführen. Im folgenden wird Bezug auf die vorab geschilderte Kondensatorformel genommen. $\varepsilon_0$ ist eine Naturkonstante und daher nicht zu verändern. Die Fläche A ist eine konstruktionsbedingt nur in engen Grenzen zu variierende Größe. Damit ist das Produkt $\varepsilon_0 \times A$ konstant. Es ergibt sich somit nach Umstellung folgende Gleichung: $C = K \times \varepsilon/d$. In diesem Fall ist die Konstante K das Produkt aus $\varepsilon_0$ und der Fläche A. Durch entsprechende Fertigungsverfahren wird A im Bereich von zwei bis fünf Prozent konstant gehalten und ist so ohne wesentlichen Einfluß auf das gesamte System. Die Kapazität C ist folglich direkt proportional zum Quotienten aus $\varepsilon_r$ und d. Unter dem Gesichtspunkt, daß die Grundkapazität $C_0$ möglichst klein sein soll, muß ein Kunststoff gewählt werden, bei dem $\varepsilon_r$ möglichst klein und die Dicke d möglichst groß ist. Dies führt zu einem kleinen Quotienten. Bei Polyethylen mit einer Dicke von 2,5 mm und einem $\varepsilon_r$ von 2,5 ist der Quotient beispielsweise 1,0. Die Grundkapazität wird dadurch nur um den Faktor 1 verstärkt.

Analoge Überlegungen können für den Handkondensator $C_{var}$ angestellt werden. Bei Weich-PVC oder einem vergleichbaren Kunststoff, der laut Werkstofftabelle ein $\varepsilon_r$ von 6,0 bis 6,5 und eine Dicke d von 1,5 mm aufweist, ergibt sich ein Quotient von 6 : 1,5 = 4. Das bedeutet, die Kapazität $C_{var}$ wird um den Faktor 4 verstärkt. Dadurch wird der relativ kleine Meßeffekt durch die anliegende Hand verstärkt.

Frequenzmessungen bzw. Periodendauermessungen ergaben eine Änderung der Periodendauer von bis zu 45 Prozent.

Die Frequenz kann entweder manuell mit Trimmern pro Handgriff oder durch eine weitere Schaltung eingestellt werden, die im Leerlauf die Grundkapazität und damit die Grundfrequenz erkennt und entsprechende Änderungen auswertet.

Ein wichtiger Vorteil der vorliegenden Erfindung besteht darin, daß der Handgriff mit der zwischen zwei Kunststoffolien eingebetteten Kupferfolie auf beliebigen Maschinen, wie Rasenmähern, Pflügen etc. eingesetzt werden kann.

Im folgenden wird die Erfindung anhand eines Beispiels und mit Bezug auf die beiliegenden Zeichnung näher erläutert.

Figur 1a zeigt einen Querschnitt durch einen kapazitiven Sensor der erfindungsgemäßen Totmanneinrichtung entlang der Linie A-B in Fig. 1b.

Figur 1b zeigt einen Längsschnitt durch einen kapazitiven Sensor der erfindungsgemäßen Totmanneinrichtung.

Figur 2 zeigt eine Heckansicht eines Motormähers.

Figur 3 zeigt ein Schema des Sicherheitskreises der erfindungsgemäßen Totmanneinrichtung.

Figur 4 zeigt die Stromversorgung der erfindungsgemäßen Totmanneinrichtung.

Figur 5 zeigt die Auswertelogik der erfindungsgemäßen Totmanneinrichtung.

Figur 6 zeigt die Kupferwicklungen in dem Sensor der erfindungsgemäßen Totmanneinrichtung.

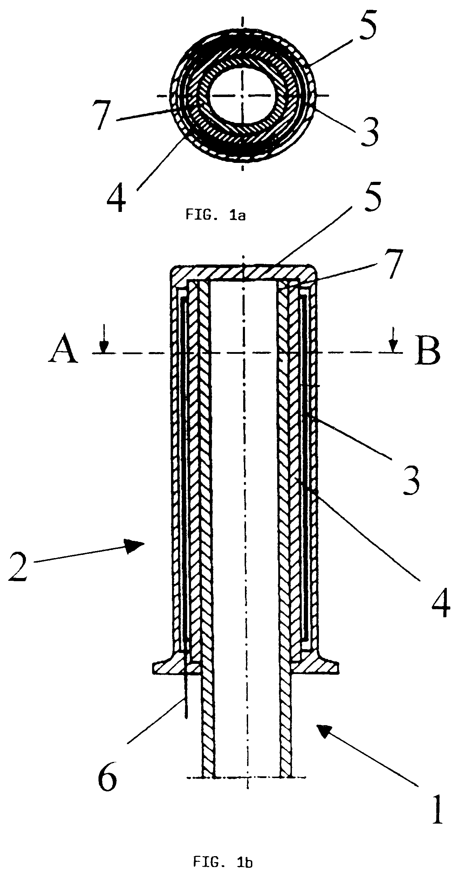

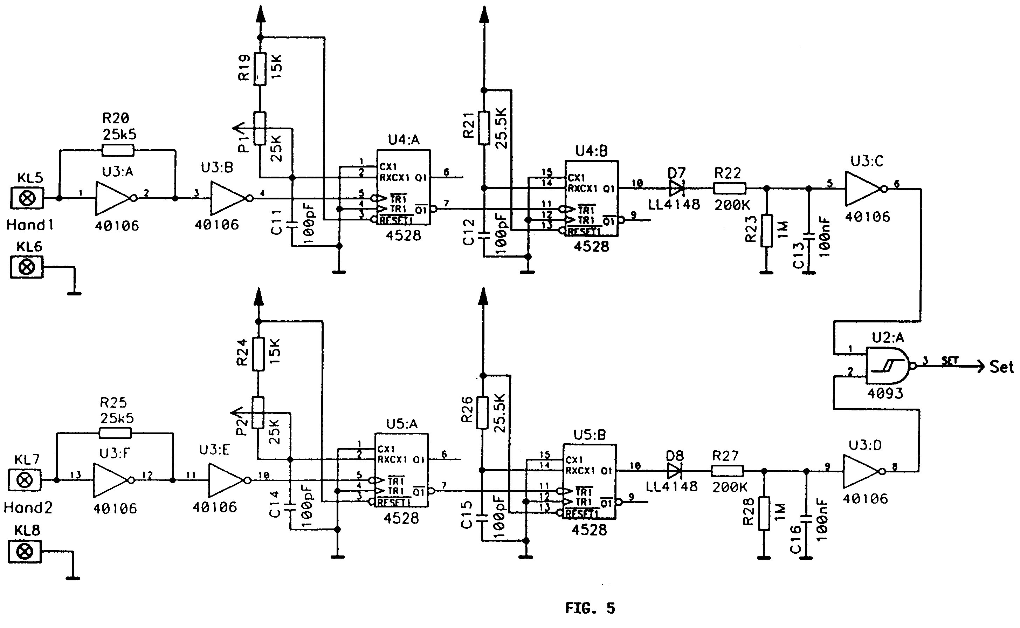

Zur Erfassung der Hand des Benutzers an einem Handgriff 1 wird, wie in den Figuren 1a und 1b gezeigt ist, ein kapazitiver Sensor 2 verwendet. Der kapazitive Sensor 2 umfaßt innen eine Kupferfolie 3, die zwischen zwei Kunststoffschichten oder Kunststoffolien 4 und 5 eingebettet ist. Die Kupferfolie 3 ist über ein kapazitätsarmes Koaxialkabel 6 mit einer Auswertelektronik (Figur 5) verbunden.

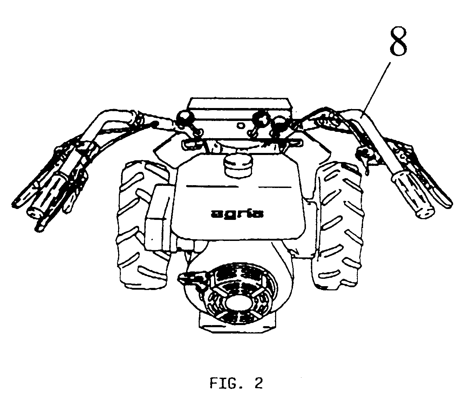

Der Handgriff 1 wird z.B. über einen Stahlholm 7 einer Maschinenlenkstange (Bezugszeichen 8 in Fig. 2) gestülpt. Dadurch ergibt sich zwischen Kupferfolie 3 und der inneren Kunststoffschicht 4 aus PE eine bestimmte Grundkapazität $C_0$, die einem ersten Kondensator entspricht und konstant ist. Die Kupferfolie 3 bildet in Verbindung mit der äußeren Kunststoffschicht 5 aus PVC einen zweiten Kondensator einer (nicht gezeigten) Hand des Bedien-personals bzw. zur Erde.

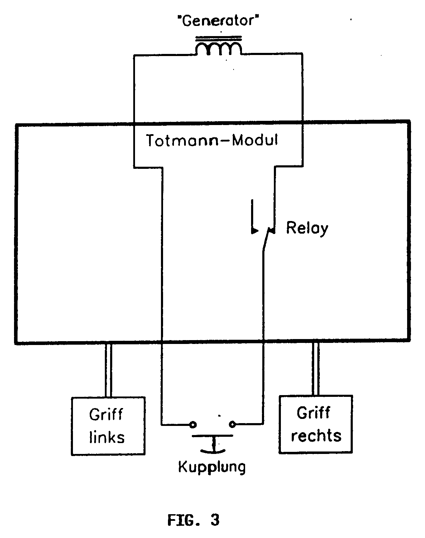

Der in Fig. 3 gezeigte Sicherheitskreis besteht aus dem externen Kupplungsschalter und dem Schließer des Relais. Während der Arbeit ist der Kupplungsschalter geschlossen. Wird durch ein Loslassen der Griffe das Relais angeschaltet, dann wird der Sicherheitskreis geschlossen und der Motor schaltet ab.

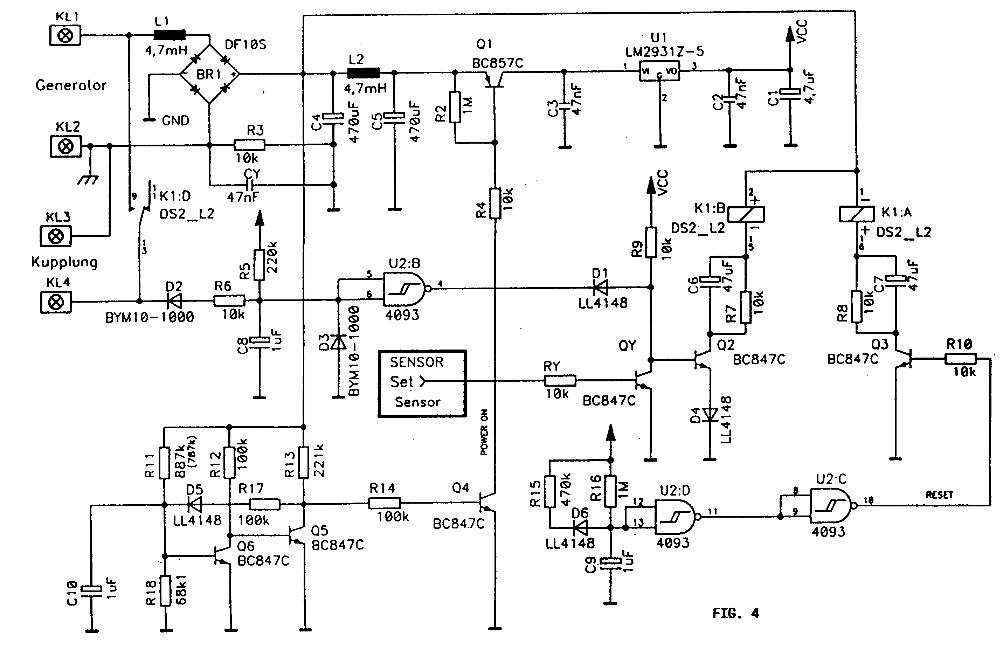

Die gesamte Schaltung wird, wie in Fig. 4 gezeigt, durch die Kurzschlußwicklung des Motors versorgt. Bei herkömmlichen Totmanneinrichtungen dient die Kurzschlußwicklung nur als Motorabsteller. Erfindungsgemäß wird die Kurzschlußwicklung als Generator umfunktioniert. Die Wicklung erzeugt nur sehr wenig Energie. Der Innenwiderstand des Generators ist relativ hochohmig (ca. 3,5 kOhm). Außerdem erzeugt der Generator hochfrequente Spannungsimpulse. Die Kurzschlußwicklung sollte möglichst nicht belastet werden, da schon einige mA den Motor aus dem "Gleichgewicht" bzw. zum Stillstand bringen. Die Spannungsimpulse werden über einen Gleichrichter gleichgerichtet. Die Induktivitäten entfernen die hochfrequenten Anteile der Spannung. Die großen Elkos glätten und speichern die Spannung.

Die in Fig. 5 gezeigte Auswertelogik umfaßt die Spannungsüberwachung am Eingang und die Steuerung des bistabilen Relais. Die Spannungsüberwachung erkennt anhand der Spannung, ob der Motor läuft. Ab einer bestimmten Spannung wird für den Rest der Schaltung die Stromversorgung angeschaltet. Dadurch wird ein Reset ausgelöst und der Sicherheitskreis wird unterbrochen - Startvorgang. Der Kupplungsschalter wird von der Logik abgefragt. Die Logik erkennt, ob die Kupplung gezogen oder gelöst ist. Liefert der Sensor ein Set-Signal, dann wird der Sicherheitskreis nur geschlossen, wenn die Kupplung gelöst ist. Das Set-Signal bedeutet "Sicherheitskreis schließen".

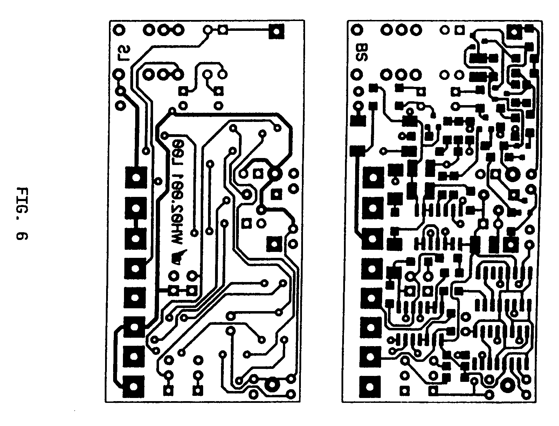

Die Aufgabe des in Fig. 6 gezeigten Sensors ist die Überwachung der Griffe. Die Überwachung erfolgt auf kapazitiver Basis. Die Kupferfolie im Handgriff bildet über das Metallrohr der Maschine eine Grundkapazität aus. Wenn man den Griff berührt, wird durch den menschlichen Körper und die Erde eine Kapazitätsänderung bewirkt. Diese Kapazitätsänderung kann mit Hilfe eines Oszillators in eine Frequenzänderung gewandelt werden, die dann von der Elektronik ausgewertet werden kann.

Im Schaltplan in Fig. 5 sind zwei gleiche Sensorteile zu erkennen. Diese sind jeweils für den linken und den rechten Griff. Im folgenden wird nur ein Sensorteil beschrieben. Der Sensor besteht am Eingang aus einem Oszillator, der durch die Kapazität im Handgriff eine Frequenz erzeugt. Im unberührten Zustand schwingt der Oszillator auf einer hohen Grundfrequenz, welche ein Set-Signal zur Folge hat. Berührt man den Griff, dann vergrößert sich die Kapazität, die Frequenz verringert sich und das Set-Signal wird nicht erzeugt.

Die Frequenz wird auf ein einstellbares Monoflop geführt. Das Monoflop wird so eingestellt, daß es bei niedriger Frequenz keine oder wenige Impulse erzeugt, während es bei hoher Frequenz viele Impulse abgibt. Diesem Monoflop ist noch ein zweites Monoflop nachgeschaltet, um die Impulse auf eine definierte Breite zu bringen.

Nach dem zweiten Monoflop werden die Impulse über ein R-C-Glied integriert. Diese Integrierung filtert eventuelle Störsignale. Dem R-C-Glied ist ein Schmitt-Trigger-Inverter nachgeschaltet, der bei einer bestimmten Schwelle ein Set-Signal abgibt. Am Sensorausgang werden die Set-Signale über ein logisches ODER verknüpft und liefern somit das eigentliche Set-Signal für die Logik.

Der Aufwand zur Versorgung und Ansteuerung des Relais läßt sich durch Akkubetrieb minimieren. Dabei wird das Relais durch ein gewöhnliches monostabiles Relais ersetzt. Zur Ansteuerung sind nur wenige Komponenten aus dem in Figur 4 gezeigten Schaltplan erforderlich.

Die erfindungsgemäße Totmanneinrichtung funktioniert wie folgt:

a) Zum Starten des Motors muß die Kupplung gezogen werden. Der Sicherheitskreis, bestehend aus Relais und Kupplungsschalter, wird unterbrochen. Der Motor kann nun anlaufen. Um der elektronischen Schaltung genügend Energie zu liefern, sollte man den Motor beim Starten auf halber Vollgasstellung hochlaufen lassen.

b) Wenn mit der Arbeit begonnen wird, muß ein Griff angefaßt werden, während mit der anderen Hand die Kupplung gelöst wird. Beim Arbeiten muß immer mindestens ein Griff angefaßt werden.

c) Der Motor schaltet sofort ab, wenn man während der Arbeit beide Griffe losläßt. Die Arbeit kann nur durch einen Neustart wie unter a) beschrieben fortgesetzt werden.

Sollte die Arbeit einmal kurz unterbrochen werden, so kann man die Kupplung ziehen und die Griffe loslassen. Der Motor wird dann nicht abgeschaltet. Wenn die Arbeit wieder aufgenommen wird, muß man wie unter b) beschrieben fortfahren.

**Patentansprüche**

1.  Totmanneinrichtung, insbesondere für mitgängergeführte und/oder handgehaltene motorbetriebene Bearbeitungsmaschinen, mit mindestens einem Handgriff zum Führen und/oder Halten der Maschine, einem Sicherheitskreis und einer Auswertelektronik mit zugehöriger Schaltung, dadurch gekennzeichnet, daß zumindest ein Bereich des Handgriffs (1) einen kapazitiven Sensor (2) zur Erfassung mindestens einer Hand eines Benutzers aufweist.

2.  Totmanneinrichtung nach Anspruch 1, dadurch gekennzeichnet, daß der kapazitive Sensor (2) mehrere Schichten (3, 4, 5, 7) umfaßt, die abwechselnd von einer metallischen Elektrode (3, 7) und einem Dielektrikum (4, 5) gebildet werden, wobei die bezogen auf den Handgriff (1) außen angeordnete Schicht (5) von einem Dielektrikum gebildet wird.

3.  Totmanneinrichtung nach Anspruch 2, dadurch gekennzeichnet, daß das bezogen auf den Handgriff (1) innen angeordnete Dielektrikum (4) eine kleinere Dielektrizitätszahl als das bezogen auf den Handgriff außen angeordnete Dielektrikum (5) aufweist.

4.  Totmanneinrichtung nach Anspruch 3, dadurch gekennzeichnet, daß das bezogen auf den Handgriff (1) innen angeordnete Dielektrikum (4) eine Dielektrizitätszahl von etwa 2,5 und das bezogen auf den Handgriff (1) außen angeordnete Dielektrikum (5) eine Dielektrizitätszahl von etwa 6,0 bis 6,5 aufweist.

5.  Totmanneinrichtung nach einem der Ansprüche 2 bis 4, dadurch gekennzeichnet, daß das Dielektrikum (4, 5) aus Kunststoff besteht.

6.  Totmanneinrichtung nach Anspruch 5, dadurch gekennzeichnet, daß das bezogen auf den Handgriff (1) innen angeordnete Dielektrikum (4) aus Polyethylen und das bezogen auf den Handgriff außen angeordnete Dielektrikum (5) aus Polyvinylchlorid besteht.

7.  Totmanneinrichtung nach einem der vorhergehenden Ansprüche, dadurch gekennzeichnet, daß der kapazitive Sensor (2) vier Schichten (3, 4, 5, 7) aufweist, die relativ zum Handgriff (1) in der Richtung von innen nach außen von einer Stahlschicht (7), einer Polyethylenschicht (4), einer Kupferschicht (3) und einer Polyvinylchloridschicht (5) gebildet werden.

8.  Totmanneinrichtung nach Anspruch 7, dadurch gekennzeichnet, daß die Kupferschicht (3) über ein kapazitätsarmes Koaxialkabel (6) mit der Auswertelektronik verbunden ist.

9.  Totmanneinrichtung nach einem der vorhergehenden Ansprüche, dadurch gekennzeichnet, daß der kapazitive Sensor (2) zylinderförmig ist.

FIG. 1a

FIG. 1b

FIG. 2

EP 0 701 917 A1

"Generator"

Totmann-Modul

Relay

Griff
links

Griff
rechts

Kupplung

FIG. 3

FIG. 4

EP 0 701 917 A1

FIG. 5

EP 0 701 917 A1

FIG. 6

Europäisches
Patentamt

**EUROPÄISCHER RECHERCHENBERICHT**

Nummer der Anmeldung

EP 95 11 4476

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | GB-A-1 317 761 (LANSING BAGNALL LTD.) 23.Mai 1973 | 1 | B60K28/04 H03K17/96 |
| Y | * Seite 1, Zeile 9 - Zeile 70 * | 2,5,9 | |
| | --- | | |
| Y | FR-A-2 557 711 (STEUERUNGSTECHNIK GMBH.) 5.Juli 1985 * Seite 3, Zeile 5 - Zeile 26; Abbildungen 1,2 * | 2,5,9 | |
| | --- | | |
| A | FR-A-2 224 067 (R. BARUFFATO) 31.Oktober 1974 * Anspruch 1; Abbildung 1 * | 1 | |
| | --- | | |
| P,X | DE-A-43 44 187 (MAGENWIRTH GMBH.) 29.Juni 1995 * Spalte 1, Zeile 31 - Zeile 50; Abbildung 3 * | 1,2,5,9 | |
| | ----- | | |

**RECHERCHIERTE SACHGEBIETE (Int.Cl.6)**

B60K
H03K

Der vorliegende Recherchenbericht wurde für alle Patentansprüche erstellt

| Recherchenort | Abschlußdatum der Recherche | Prüfer |
|---|---|---|
| BERLIN | 18.Dezember 1995 | Wiberg, S |